# EUROPEAN PATENT APPLICATION

(11) **EP 4 501 684 A1**
(43) Date of publication of application: **05.02.2025**
(21) Application number: 24190766.6
(22) Date of filing: 25.07.2024
(51) Int. Cl.: B60L 3/00

(54) **DETERMINATION SYSTEM, INFORMATION PROCESSING APPARATUS, DETERMINATION METHOD, AND PROGRAM**

(30) Priority: 01.08.2023 JP 2023125714
(71) Applicant: Yokogawa Electric Corporation, Tokyo 180-8750 (JP)
(72) Inventor: UEMURA, Hideo, Tokyo, 180-8750 (JP); TERAO, Minako, Tokyo, 180-8750 (JP); NOGUCHI, Naoki, Tokyo, 180-8750 (JP)
(74) Representative: Stöckeler, Ferdinand

(57) **Abstract**

A determination system (1) includes a sensor (22) configured to measure physical properties of a target battery (41) that is a battery installed in a vehicle (40), and an information processing apparatus (10) communicably connected to the sensor (22), the information processing apparatus (10) including a controller (11). The controller (11) acquires vehicle identification information that identifies the vehicle (40), acquires first battery identification information that identifies a battery corresponding to the acquired vehicle identification information, acquires the physical properties of the target battery (41) as measured by the sensor (22), acquires second battery identification information that identifies a battery corresponding to the acquired physical properties, compares the first battery identification information with the second battery identification information to determine authenticity of the target battery installed in the vehicle (40), and outputs the result of determination of the authenticity of the target battery.

## Description

### CROSS-REFERENCE TO RELATED APPLICATION

The present application claims priority to Japanese Patent Application No. 2023-125714 filed on August 1, 2023, the entire contents of which are incorporated herein by reference.

### TECHNICAL FIELD

The present disclosure relates to a determination system, an information processing apparatus, a determination method, and a program.

### BACKGROUND

Patent literature (PTL) 1 describes determining the type of a target battery based on the inductance of the target battery. PTL 2 describes managing battery characteristics for a plurality of batteries in association with identification information on the batteries, and when the battery in a moveable body is replaced, comparing the battery characteristics of the battery as measured in the moveable body with the battery characteristics associated with the identification information on the battery.

### CITATION LIST

### Patent Literature

PTL 1: JP 2022-068657 A
PTL 2: JP 2020-149789 A

### SUMMARY

However, in a case in which a battery is replaced without authorization, such as while a battery-powered vehicle is being rented, there is room for improvement in effectively detecting unauthorized battery replacement.

It would be helpful to enable more effective detection of unauthorized battery replacement from a vehicle.

A determination system according to several embodiments is
(1) A determination system including:
   a sensor configured to measure physical properties of a target battery that is a battery installed in a vehicle; and
   an information processing apparatus that is communicably connected to the sensor and includes a controller, wherein
   the controller is configured to
      acquire vehicle identification information that identifies the vehicle,
      acquire first battery identification information that identifies a battery corresponding to the acquired vehicle identification information,
      acquire the physical properties of the target battery as measured by the sensor,
      acquire second battery identification information that identifies a battery corresponding to the acquired physical properties,
      compare the first battery identification information with the second battery identification information to determine authenticity of the target battery installed in the vehicle, and
      output a result of determination of the authenticity of the target battery.

The determination system thus determines the authenticity of the target battery installed in the vehicle by comparing the first battery identification information corresponding to the vehicle identification information with the second battery identification information corresponding to the physical properties of the target battery. It is therefore possible effectively to determine whether the battery installed in a vehicle has been replaced without authorization.

In an embodiment,
(2) the determination system of (1) may further include a camera configured to capture and acquire an image of the vehicle, wherein
the controller may be configured to acquire the vehicle identification information based on a result of analysis of the image acquired by the camera.

In this way, the vehicle identification information is acquired based on the result of analysis of an image of the vehicle, and the authenticity of the battery is then determined. It is therefore possible effectively to detect that the battery has been replaced without authorization from the corresponding vehicle.

In an embodiment,
(3) in the determination system of (2), in a case in which the vehicle identification information could not be acquired based on the result of analysis of the image, the controller may be configured to perform at least one of outputting an alert and repeating acquisition of the image of the vehicle by the camera.

In a case in which acquisition of vehicle identification information fails, it is thus possible to take measures such as outputting an alert and reacquiring the image to more reliably acquire the vehicle identification information.

In an embodiment,
(4) in the determination system of (1), the controller may be configured to
receive, from a user, input of specific information for specifying the vehicle, and
acquire the vehicle identification information based on the specific information for which input is received.

In this way, the vehicle identification information is acquired based on the specific information that is accepted as input from the user, and the authenticity of the battery is then determined. It is therefore possible effectively to detect that the battery has been replaced without authorization from the vehicle.

In an embodiment,
(5) in the determination system of any one of (1) to (4), the controller may be configured to acquire a measured value of leakage flux of the target battery as the physical properties of the target battery.

The controller thus acquires the measured value of the leakage flux of the target battery and then determines the authenticity of the battery. It therefore becomes difficult to replace a battery without authorization while not exposing that the battery is not authentic. Unauthorized replacement of batteries can therefore be effectively detected.

An information processing apparatus according to several embodiments is
(6) an information processing apparatus including a controller configured to:
acquire vehicle identification information that identifies a vehicle,
acquire first battery identification information that identifies a battery corresponding to the acquired vehicle identification information,
acquire, via a sensor, physical properties of a target battery that is a battery installed in the vehicle,
acquire second battery identification information that identifies a battery corresponding to the acquired physical properties,
compare the first battery identification information with the second battery identification information to determine authenticity of the target battery installed in the vehicle, and
output a result of determination of the authenticity of the target battery.

The information processing apparatus thus determines the authenticity of the target battery installed in the vehicle by comparing the first battery identification information corresponding to the vehicle identification information with the second battery identification information corresponding to the physical properties of the target battery. It is therefore possible effectively to determine whether the battery installed in a vehicle has been replaced without authorization.

A determination method according to several embodiments is
(7) a determination method for an information processing apparatus including a controller, the determination method including:
acquiring, by the controller, vehicle identification information that identifies a vehicle;
acquiring, by the controller, first battery identification information that identifies a battery corresponding to the acquired vehicle identification information;
acquiring, by the controller via a sensor, physical properties of a target battery that is a battery installed in the vehicle;
acquiring, by the controller, second battery identification information that identifies a battery corresponding to the acquired physical properties;
comparing, by the controller, the first battery identification information with the second battery identification information to determine authenticity of the target battery installed in the vehicle; and
outputting, by the controller, a result of determination of the authenticity of the target battery.

The determination method thus determines the authenticity of the target battery installed in the vehicle by comparing the first battery identification information corresponding to the vehicle identification information with the second battery identification information corresponding to the physical properties of the target battery. It is therefore possible effectively to determine whether the battery installed in a vehicle has been replaced without authorization.

A program according to several embodiments is
(8) a program configured to cause a computer to perform operations including:
acquiring vehicle identification information that identifies a vehicle;
acquiring first battery identification information that identifies a battery corresponding to the acquired vehicle identification information;
acquiring physical properties of a target battery that is a battery installed in the vehicle;
acquiring second battery identification information that identifies a battery corresponding to the acquired physical properties;
comparing the first battery identification information with the second battery identification information to determine authenticity of the target battery installed in the vehicle; and
outputting a result of determination of the authenticity of the target battery.

The program thus determines the authenticity of the target battery installed in the vehicle by comparing the first battery identification information corresponding to the vehicle identification information with the second battery identification information corresponding to the physical properties of the target battery. It is therefore possible effectively to determine whether the battery installed in a vehicle has been replaced without authorization.

According to an embodiment of the present disclosure, unauthorized battery replacement from a vehicle can more effectively be detected.

### BRIEF DESCRIPTION OF THE DRAWINGS

In the accompanying drawings:
FIG. 1 is a diagram illustrating an overview of a determination system according to an embodiment;
FIG. 2 is a block diagram illustrating an example configuration of the information processing apparatus in FIG. 1;
FIG. 3 is a diagram illustrating a configuration example of a determination system according to an embodiment;
FIG. 4 is a diagram schematically illustrating an example of measurement of the physical properties of a battery;
FIG. 5 is a diagram illustrating an example of a vehicle DB;
FIG. 6 is a diagram illustrating an example of a battery DB;
FIG. 7 is a diagram illustrating a configuration example of a determination system according to an embodiment; and
FIG. 8 is a flowchart illustrating an example of operations of the determination system.

### DETAILED DESCRIPTION

### <Comparative Example>

As a configuration according to a comparative example, PTL 1 (claim 1) recites, "a battery type determination apparatus including an output controller configured to instruct a current application circuit to apply a specific current to a target battery, a voltage response measurement unit configured to measure a voltage response of the target battery to the current applied by the output controller, a calculation unit configured to calculate an inductance value of the target battery based on a current value applied by the output controller and a voltage value measured by the voltage response measurement unit, and a determination unit configured to determine a type of the target battery based on a prescribed value of inductance according to a type of the target battery and the inductance value of the target battery calculated by the calculation unit".

PTL 2 (claim 1) recites, "a battery management system including a first management apparatus configured to associate battery characteristics measured under predetermined conditions with identification information on each battery for each battery in a plurality of batteries that can be installed in a moveable body powered by a battery, and a second management apparatus configured to perform a comparison, when a first battery installed in the moveable body is replaced with a second battery, between the battery characteristics of the second battery measured under the predetermined conditions in the moveable body and the battery characteristics associated with the identification information on the second battery in the first management apparatus, and in a case in which the comparison fails, prohibit use of the second battery in the moveable body".

However, in a case in which a battery is replaced without authorization, such as while a battery-powered vehicle is being rented, the configuration according to the comparative example has room for improvement in effectively detecting unauthorized battery replacement. For example, the secondary battery installed in an xEV accounts for the majority of the vehicle body cost. Therefore, there is a risk of the battery being swapped for a non-genuine product of inferior quality. In particular, xEVs that are leased or rented are often used by an unspecified number of people other than the owner, yielding a high risk of replacement with non-genuine products. It would be helpful to provide a highly versatile system for identifying the type of on-board secondary battery and determining its authenticity in order to quickly identify such replacement.

### <Embodiment>

An embodiment of the present disclosure is now described with reference to the drawings. Portions having an identical configuration or function in the drawings are labeled with the same reference signs. In the explanation of the present embodiment, a redundant description of identical portions may be omitted or simplified as appropriate.

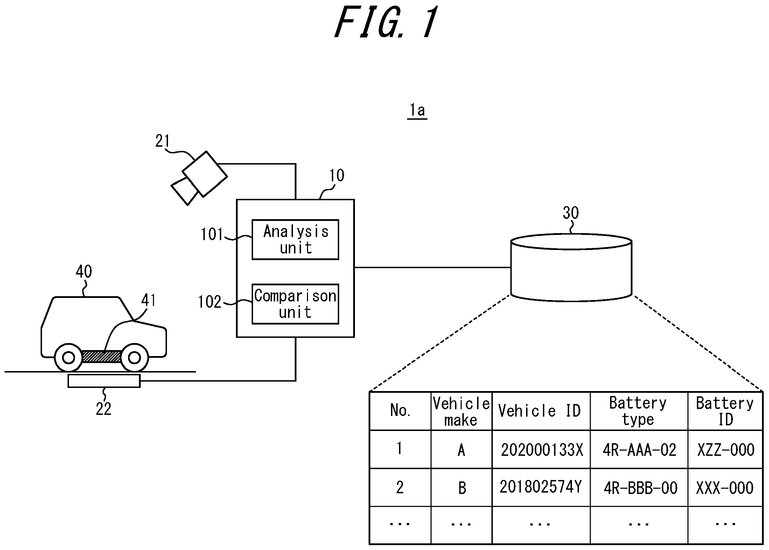

FIG. 1 is a diagram illustrating an outline of a determination system 1a according to an embodiment. The determination system 1a determines the authenticity of a battery 41 installed in a vehicle 40. The vehicle 40 is an electric vehicle powered by electric energy from the battery 41. Examples of the vehicle 40 include a Battery Electric Vehicle (BEV), Hybrid Electric Vehicle (HEV), and Plug in Hybrid Electric Vehicle (PHEV) (these electric vehicles are collectively referred to as an "xEV").

The determination system 1a includes an information processing apparatus 10, a camera 21, a physical property sensor 22, and a vehicle information database (DB) 30. Determination systems 1a, 1b, and 1c may be collectively referred to below as the "determination system 1". The information processing apparatus 10 is communicably connected to the camera 21, the physical property sensor 22, and the vehicle information DB 30.

The camera 21 captures and acquires images of the vehicle 40. The camera 21 may, for example, be configured by a digital camera. The images are, for example, used to acquire information necessary to specify the vehicle 40, such as the vehicle identification number (VIN), vehicle make, manufacturer, model (generation), grade, and license plate information. The camera 21 may acquire one or more images, including, for example, the license plate, a portion of the vehicle 40 where the VIN is displayed, and the external appearance allowing identification of the body shape of the vehicle 40. The camera 21 may acquire images not only of the vehicle 40, but also of a document listing information necessary to specify the vehicle 40, such as a vehicle inspection certificate.

The physical property sensor 22 measures physical properties of the battery 41 (target battery) installed in the vehicle 40. The physical property sensor 22 is, for example, a magnetic sensor that measures the leakage flux formed around the battery 41, but this example is not limiting. The physical property sensor 22 may be an ultrasonic sensor, a current sensor, or the like. Other examples of the physical property sensor 22 include sensors that can measure current characteristics or changes in the external magnetic field as the battery 41 is charged or discharged, sonic reflection characteristics derived from the structure of the battery 41, or the internal solvent material of the battery 41 and its distribution.

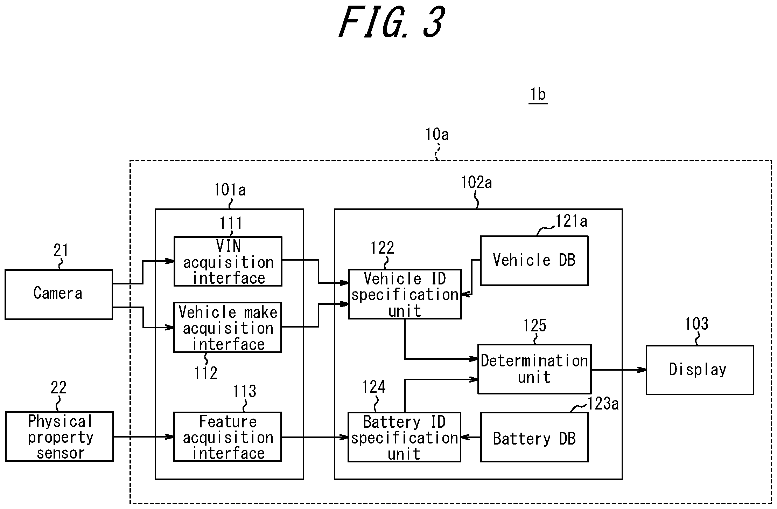

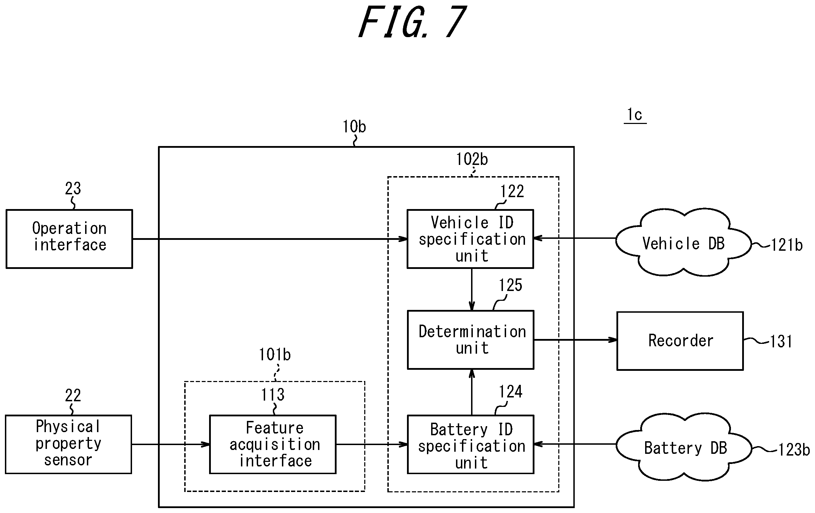

The vehicle information DB 30 stores a correspondence relationship between the vehicle ID (vehicle identification information) that identifies the vehicle 40 and the battery ID (battery identification information) that identifies the battery 41. In the example in FIG. 1, the vehicle information DB 30 indicates not only the vehicle ID and battery ID, but also the correspondence relationship between the vehicle make and battery type. In FIG. 1, the vehicle information DB 30 is provided outside the information processing apparatus 10, but at least some functions of the vehicle information DB 30 may be provided in the information processing apparatus 10. The vehicle information DB 30 may be configured by a plurality of DBs (such as the vehicle DB 121 (121a, 121b) and battery DB 123 (123a, 123b) described below with reference to FIGS. 3 and 7), according to the type of information.

The information processing apparatus 10 determines the authenticity of the battery 41 installed in the vehicle 40. The information processing apparatus 10 is, for example, a computer such as a Personal Computer (PC), Workstation (WS), or tablet terminal. The information processing apparatus 10 includes an analysis unit 101 and a comparison unit 102. The analysis unit 101 analyzes images acquired by the camera 21 and physical properties of the battery 41 as measured by the physical property sensor 22. The comparison unit 102 determines the authenticity of the battery 41 by comparing the battery ID corresponding to the vehicle ID acquired by analyzing the image and the battery ID acquired by analyzing the physical properties of the battery 41. As described below, the analysis unit 101 and the comparison unit 102 may be realized by software.

In the above configuration, the information processing apparatus 10 acquires a vehicle ID identifying the vehicle 40 based on analysis of the image acquired by the camera 21, input, from the user, of information for specifying the vehicle 40, and the like. The information processing apparatus 10 acquires a first battery ID (first battery identification information) that identifies the battery 41 corresponding to the acquired vehicle ID by, for example, referring to the vehicle information DB 30. The information processing apparatus 10 acquires the physical properties of the battery 41 installed in the vehicle 40 and acquires a second battery ID (second battery identification information) that identifies the battery 41 corresponding to the acquired physical properties by, for example, referring to the vehicle information DB 30. The information processing apparatus 10 compares the first battery ID and the second battery ID to determine the authenticity of the battery 41 installed in the vehicle 40 and outputs the result of the determination of authenticity of the battery 41.

The determination system 1 thus determines the authenticity of the battery 41 by comparing the battery ID corresponding to the vehicle ID for identifying the vehicle 40 with the battery ID identified based on the physical properties of the battery 41. The determination system 1 can therefore effectively determine whether the battery 41 installed in the vehicle 40 has been replaced without authorization.

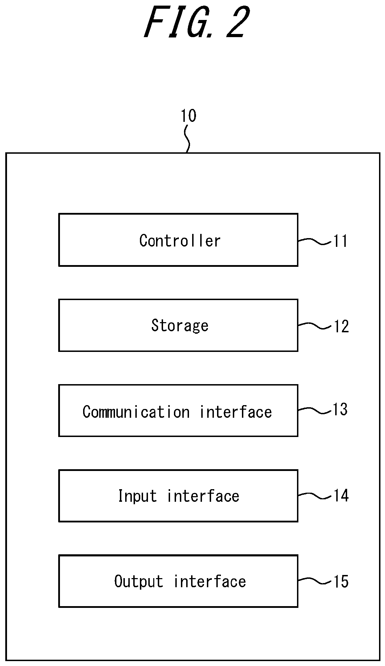

FIG. 2 is a block diagram illustrating an example configuration of the information processing apparatus 10 in FIG. 1. The information processing apparatus 10 is one computer or a plurality of communicably connected computers. As illustrated in FIG. 2, the information processing apparatus 10 includes a controller 11, a storage 12, a communication interface 13, an input interface 14, and an output interface 15.

The controller 11 includes one or more processors. The "processor" in an embodiment is a general-purpose processor or a dedicated processor specialized for particular processing, but these examples are not limiting. The controller 11 is communicably connected with each component of the information processing apparatus 10 and controls operations of the information processing apparatus 10 overall.

The storage 12 includes any appropriate memory module, such as a hard disk drive (HDD), a solid state drive (SSD), read-only memory (ROM), and random access memory (RAM). The storage 12 may, for example, function as a main memory, an auxiliary memory, or a cache memory. The storage 12 stores any information used for operations of the information processing apparatus 10. For example, the storage 12 may store a system program, an application program, various types of information received by the communication interface 13, and the like. The storage 12 is not limited to being internal to the information processing apparatus 10 and may be an external database or an external storage module. For example, the storage 12 may store images acquired by the camera 21 and measurements of physical properties as acquired by the physical property sensor 22.

The communication interface 13 includes any appropriate communication module capable of connecting and communicating with other apparatuses, such as a scanner, by any appropriate communication technology. The communication interface 13 may further include a communication control module for controlling communication with other apparatuses and a memory module for storing communication data, such as identification information, necessary for communicating with other apparatuses. For example, the communication interface 13 may communicate with the camera 21, the physical property sensor 22, and the vehicle information DB 30.

The input interface 14 includes one or more input interfaces that receive an input operation from an operator and acquire input information based on the user operation. For example, the input interface 14 may be physical keys, capacitive keys, a pointing device, a touchscreen integrally provided with a display of the output interface 15, a microphone that receives audio input, or the like, but is not limited to these.

The output interface 15 includes one or more output interfaces that output information to the operator to notify the operator. For example, the output interface 15 may be a display that outputs information as images, a speaker that outputs information as sound, or the like, but these examples are not limiting. Such a display may, for example, be a liquid crystal panel display or an organic electroluminescent (EL) display. The input interface 14 and/or the output interface 15 described above may be configured integrally with the information processing apparatus 10 or be provided separately.

The functions of the information processing apparatus 10 (for example, the analysis unit 101 and the comparison unit 102) can be implemented by the processor included in the controller 11 executing a computer program (program) according to the present embodiment. That is, the functions of the information processing apparatus 10 can be implemented by software. The computer program causes a computer to execute the processing of the steps included in the operations of the information processing apparatus 10 to implement the functions corresponding to the processing of the steps. That is, the computer program is a program for causing a computer to function as the information processing apparatus 10 according to the present embodiment. The computer program may be recorded on a computer-readable recording medium. Examples of the program include an equivalent to the program represented as information provided for processing by an electronic computer. For example, data that is not a direct command for a computer but that has the property of specifying processing by the computer corresponds to the "equivalent to the program".

A portion or all of the functions of the information processing apparatus 10 may be implemented by a dedicated circuit included in the controller 11. In other words, a portion or all of the functions of the information processing apparatus 10 may be implemented by hardware. Furthermore, the information processing apparatus 10 may be implemented by a single computer or implemented by cooperation among a plurality of computers.

FIG. 3 is a diagram illustrating an example configuration of a determination system 1b according to an embodiment. As described above, at least some functions of the vehicle information DB 30 may be provided in the information processing apparatus 10a. In the determination system 1b in FIG. 3, the vehicle information DB 30 is provided in a comparison unit 102a of the information processing apparatus 10a as a vehicle DB 121a and a battery DB 123a. In FIG. 3, the information processing apparatus 10a includes an analysis unit 101a and the comparison unit 102a. The analysis unit 101a includes a VIN acquisition interface 111, a vehicle make acquisition interface 112, and a feature acquisition interface 113. The comparison unit 102a includes a vehicle DB 121a, a vehicle ID specification unit 122, a battery DB 123a, a battery ID specification unit 124, and a determination unit 125.

The VIN acquisition interface 111 analyzes the image acquired by the camera 21 to acquire the VIN of the vehicle 40. Specifically, the VIN acquisition interface 111 may acquire the VIN by analyzing a captured image of a vehicle inspection certificate containing the VIN or a captured image of the portion of the vehicle 40 with the VIN stamped thereon.

The vehicle make acquisition interface 112 analyzes the image acquired by the camera 21 to acquire the make of the vehicle 40. Specifically, the vehicle make acquisition interface 112 may acquire an automobile type category, such as a standard passenger car or a small cargo vehicle, as the make of the vehicle 40. The vehicle make acquisition interface 112 may acquire the vehicle make by analyzing a captured image of the external features, of the vehicle 40, such as the exterior, a captured image of emblems, a vehicle inspection certificate, or the like. The vehicle make may also include information such as the model (generation), grade, and manufacturer.

On the basis of the image acquired by the camera 21, the analysis unit 101a may acquire specific information other than the vehicle number and vehicle make to specify the vehicle 40. For example, the analysis unit 101a may analyze the image of the vehicle 40 captured by the camera 21 and extract a number sequence and character string in the license plate as the specific information. Alternatively, the analysis unit 101a may acquire information such as the model (generation) and grade as specific information. The analysis unit 101a may also acquire information for specifying the vehicle 40 other than on the basis of the image acquired by the camera 21. For example, the information processing apparatus 10a may connect to the On Board Diagnostics (OBD) of the vehicle 40 by an interface or scanning tool and acquire information for specifying the vehicle 40 from the OBD. As described below with reference to FIG. 7, the information processing apparatus 10a may accept input from the user of information for specifying the vehicle 40.

The analysis unit 101a may also output an alert to the user in a case in which the analysis unit 101a fails to acquire the VIN, vehicle make, or other specific information of the vehicle 40 based on the image from the camera 21. Specifically, the analysis unit 101a may display an image on the display of the output interface 15 indicating failure to acquire the VIN, vehicle make, or other specific information of the vehicle 40, or may output an alarm sound from the speaker of the output interface 15. The analysis unit 101a may also repeat acquisition of the image using the camera 21 in a case in which the analysis unit 101a fails to acquire the VIN, vehicle make, or other specific information of the vehicle 40. When repeating acquisition of the image, the analysis unit 101a may display, on the display of the output interface 15, a guide on how to capture the image using the camera 21 in order to acquire a better image.

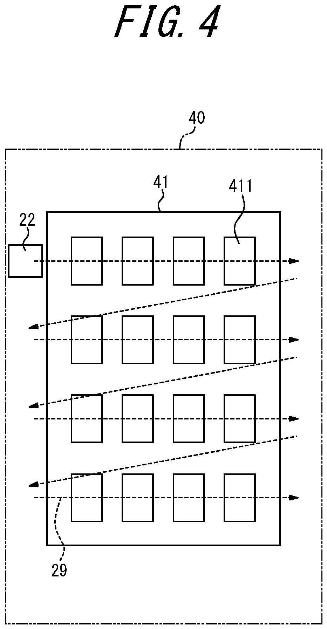

FIG. 4 is a diagram schematically illustrating an example of measurement of the physical properties of the battery 41. FIG. 4 depicts a horizontal plane when observing the bottom of the vehicle 40 from a position vertically below. As illustrated in FIG. 4, the battery 41 includes cells 411 arranged in a grid in the horizontal plane. As illustrated in FIG. 4, the physical property sensor 22 may measure the magnetic flux while scanning the cells 411 one row at a time along a scanning direction 29 to acquire a spatial distribution of the surrounding magnetic flux formed by the battery 41.

The feature acquisition interface 113 acquires features from the measured values of the physical properties of the battery 41 acquired by the physical property sensor 22. For example, in a case in which measured values of the leakage flux formed around the battery 41 are acquired, the feature acquisition interface 113 may acquire information about the spatial frequency, amplitude, and the like of the leakage flux as features.

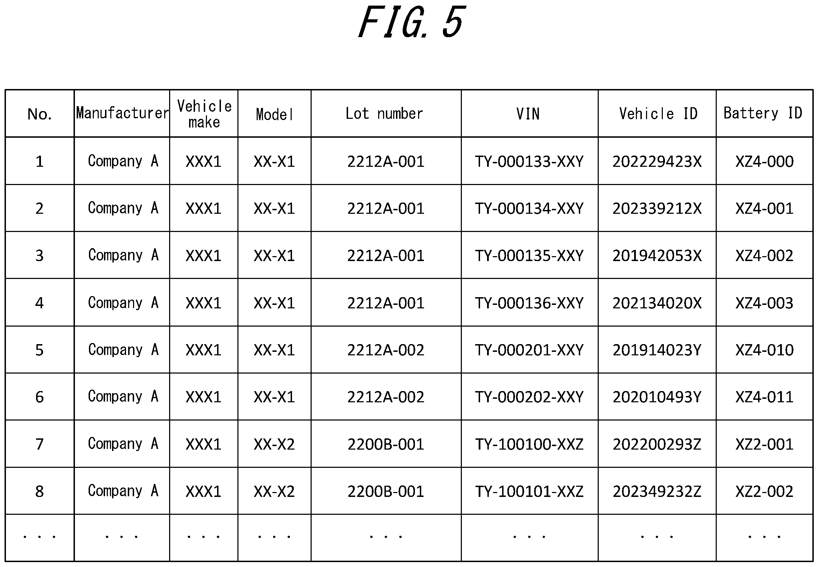

The vehicle DB 121a (the same applies to the vehicle DB 121b described below with reference to FIG. 7) is a database indicating a correspondence relationship between the information for specifying the vehicle 40 on the one hand and the vehicle ID and battery ID on the other. FIG. 5 is a diagram illustrating an example of the vehicle DB 121 (121a, 121b).

In FIG. 5, the "manufacturer" is the manufacturer of the vehicle 40. The "vehicle make" is the automobile type category, such as a standard passenger car or a small cargo vehicle. The "model" is a classification index that designates automobiles with the same structure, equipment, and performance. The "model" may, for example, be expressed as an identifying symbol that is a combination of letters and numbers to classify the make and model of an automobile.

The "lot number" is a number (serial number) assigned to each unit of the vehicle 40 that is produced with the same specifications. The "VIN" is an individual identification number assigned to each vehicle 40 by the Ministry of Land, Infrastructure, Transport and Tourism upon notification from the manufacturer of the vehicle 40.

The "vehicle ID" is identification information that uniquely identifies the vehicle 40 in the determination system 1. The "vehicle ID" is unique identification information that is different from other information such as the "VIN" and the "lot number" in the present embodiment, but the "vehicle ID" may be the same as or a combination of other information such as the "VIN" and the "lot number".

The "battery ID" is identifying information that identifies the battery 41 installed in the vehicle 40. The "battery ID" is unique information different from other information such as the serial number of the battery 41 in the present embodiment, but the "battery ID" may be the same as or a combination of other information such as the serial number.

The vehicle ID specification unit 122 refers to the vehicle DB 121a to acquire the vehicle ID and battery ID corresponding to the identification information acquired by the VIN acquisition interface 111 and the vehicle type acquisition interface 112 to identify the vehicle 40.

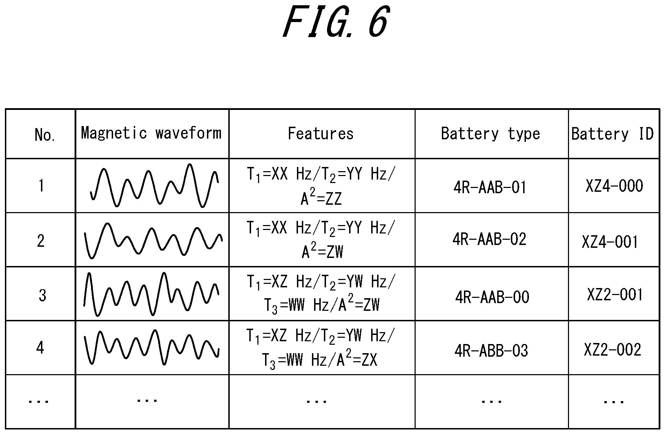

The battery DB 123a (the same applies to the battery DB 123b described below with reference to FIG. 7) is a database indicating a correspondence relationship between the features related to the physical properties of the battery 41 and the battery ID. FIG. 6 is a diagram illustrating an example of the battery DB 123 (123a, 123b).

In FIG. 6, the "magnetic waveform" is the spatial waveform of magnetism in a case in which the physical property sensor 22 is operated around the cells 411 along the scanning direction 29 in FIG. 4.

The "features" are values obtained by analyzing the measured values of the physical property sensor 22. For example, the "features" are information about the spatial frequency, amplitude, and the like of the leakage flux. In FIG. 6, for example, T₁, T₂, and T₃ are the spatial frequencies at the location where the peak was observed. A² is the square of the amplitude of the leakage flux.

The "battery type" is the type of the battery 41. For example, the "battery type" may be a number (serial number) of the battery 41 assigned to each unit that is produced.

The "battery ID" is identifying information that identifies the battery 41. In the present embodiment, the meaning of the "battery ID" in the vehicle DB 121 (121a, 121b) is the same as that of the "battery ID" in the battery DB 123 (123a, 123b).

The battery ID specification unit 124 refers to the battery DB 123a to acquire the battery ID corresponding to the features of the physical properties of the battery 41 as acquired by the feature acquisition interface 113.

The determination unit 125 determines the authenticity of the battery 41 by comparing the battery ID (first battery ID) associated with the vehicle 40 specified by the vehicle ID specification unit 122 and the battery ID (second battery ID) acquired based on analysis of the physical properties of the battery 41 specified by the battery ID specification unit 124. In a case in which the first battery ID and the second battery ID match, the determination unit 125 determines that the battery 41 installed in the vehicle 40 is authentic. Otherwise, the determination unit 125 determines that the battery 41 is not authentic.

The information processing apparatus 10a outputs the result of determination by the determination unit 125. In the example in FIG. 3, the information processing apparatus 10a outputs the result of determination by displaying the result of determination of the authenticity of the battery 41 on a display 103 of the output interface 15.

In the present embodiment, each of the functional elements described with reference to FIG. 3 is realized by software, but at least some of these functional elements may be configured by dedicated hardware.

The configuration of the determination system 1 described with reference to FIGS. 1 and 3 is an example, and various variations are possible. FIG. 7 is a diagram illustrating an example configuration of a determination system 1c according to an embodiment. In the determination system 1c, an analysis unit 101b includes the feature acquisition interface 113. A comparison unit 102b includes the vehicle ID specification unit 122, the battery ID specification unit 124, and the determination unit 125.

The determination system 1c in FIG. 7 does not include the camera 21 but instead includes an operation interface 23 that accepts operations from a user. The operation interface 23 may, for example, be configured by the input interface 14. The determination system 1c has the user input specific information for identifying the vehicle 40, acquires the vehicle ID and battery ID corresponding to the inputted specific information, and outputs the vehicle ID and battery ID to the determination unit 125.

In the determination system 1c, the vehicle DB 121b and the battery DB 123b are not included in the information processing apparatus 10b, but rather on the cloud or the like, which can communicate with the information processing apparatus 10b. The information processing apparatus 10b accesses the vehicle DB 121b and the battery DB 123b as necessary via a network including the Internet and the like.

The determination unit 125 compares the battery ID (first battery ID) associated with the specific information for specifying the vehicle 40 as inputted by the user and the battery ID (second battery ID) associated with the features of the physical properties of the battery 41 as acquired by the physical property sensor 22. In a case in which the first battery ID and the second battery ID match, the determination unit 125 determines that the battery 41 installed in the vehicle 40 is authentic. Otherwise, the determination unit 125 determines that the battery 41 is not authentic. The determination unit 125 outputs the determination result to a recorder 131. The recorder 131 is an external storage apparatus. The recorder 131 may, for example, be a Universal Serial Bus (USB) memory, network storage, or the like.

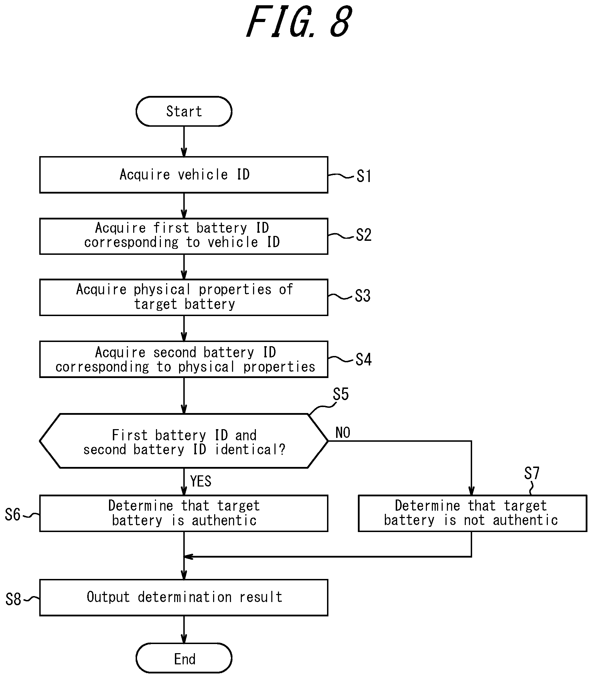

FIG. 8 is a flowchart illustrating an example of operations of the determination system 1. FIG. 8 is a flowchart illustrating operations of the information processing apparatus 10 in FIG. 1. Operations of the information processing apparatus 10 described with reference to FIG. 8 may correspond to one of the determination methods of the information processing apparatus 10. The operations of each step in FIG. 8 can be performed based on control by the controller 11 of the information processing apparatus 10.

In step S1, the controller 11 acquires a vehicle ID (vehicle identification information) to identify the vehicle 40. Specifically, the controller 11 may acquire the vehicle ID by analyzing an image obtained upon capturing an image of the vehicle 40 or by accepting input, from the user, of specific information for specifying the vehicle 40.

In step S2, the controller 11 acquires the first battery ID, which is the identification information for the battery 41 corresponding to the vehicle ID acquired in step S1. Specifically, the controller 11 may refer to the vehicle DB 121 (121a, 121b) to acquire the battery ID corresponding to the vehicle ID as the first battery ID.

In step S3, the controller 11 acquires the physical properties of the target battery, which is the battery 41 installed in the vehicle 40. Specifically, the controller 11 controls the physical property sensor 22 to acquire measured values of the physical properties of the battery 41, such as leakage flux.

In step S4, the controller 11 acquires the second battery ID, which is the identification information for the battery 41 corresponding to the physical properties of the target battery (battery 41). Specifically, the controller 11 may acquire features of the physical properties of the target battery and refer to the battery DB 123 (123a, 123b) to acquire the battery ID corresponding to the features as the second battery ID.

In step S5, the controller 11 determines whether the first battery ID acquired in step S2 and the second battery ID acquired in step S4 are identical. In a case in which the first battery ID and the second battery ID are identical (YES in step S5), the controller 11 proceeds to step S6. Otherwise (NO in step S5), the controller 11 proceeds to step S7.

In step S6, the controller 11 determines that the battery 41 (target battery) installed in the vehicle 40 is authentic.

In step S7, the controller 11 determines that the battery 41 (target battery) installed in the vehicle 40 is not authentic.

In step S8, the controller 11 outputs the determination result acquired in step S6 or step S7. Specifically, the controller 11 may display the result of determining the authenticity of the target battery on the display 103 of the output interface 15 or may output the result to the storage 12 or the recorder 131. After completing the process of step S8, the controller 11 ends the process of the flowchart.

As described above, the information processing apparatus 10 acquires the vehicle ID that identifies the vehicle 40 to acquire the first battery ID that identifies the battery 41 corresponding to the acquired vehicle ID. The information processing apparatus 10 acquires the physical properties of the battery 41 installed in the vehicle 40 and acquires the second battery ID that identifies the battery 41 corresponding to the acquired physical properties. The information processing apparatus 10 compares the first battery ID and the second battery ID to determine the authenticity of the battery 41 installed in the vehicle 40 and outputs the result of the determination of authenticity.

The information processing apparatus 10 thus determines the authenticity of the battery 41 installed in the vehicle 40 by comparing the first battery ID corresponding to the vehicle ID and the second battery ID corresponding to the physical properties of the battery 41. The information processing apparatus 10 can therefore effectively determine whether the battery 41 installed in the vehicle 40 has been replaced without authorization.

The information processing apparatus 10 may also acquire an image of the vehicle 40 and acquire the vehicle ID based on the result of analysis of the acquired image. The information processing apparatus 10 thus determines the authenticity of the battery 41 by acquiring the vehicle ID based on the result of analysis of the image of the vehicle 40, thereby making it possible to effectively detect that the battery 41 has been replaced from the vehicle 40 without authorization.

The information processing apparatus 10 may receive, from a user, input of specific information for specifying the vehicle 40 and acquire the vehicle ID based on the specific information for which input was received.

In an embodiment, the information processing apparatus 10 may acquire a measured value of the leakage flux of the battery 41 as the physical properties of the battery 41. The information processing apparatus 10 thus determines the authenticity of the battery 41 by acquiring the measured value of the leakage flux of the battery 41, thereby making it difficult to replace the battery 41 without authorization while not exposing that the battery 41 is not authentic. The information processing apparatus 10 can therefore effectively detect unauthorized replacement of the battery 41.

As described above, the determination system 1 specifies the vehicle 40 with the camera 21 or the like and acquires information for identifying the type and individual unit of the battery 41 that is expected to be installed in the vehicle 40. On the other hand, the determination system 1 is configured to acquire information for identifying the type and individual unit of the battery 41 by measuring the physical properties of the battery 41 from outside the vehicle 40. The determination system 1 detects unauthorized replacement of the battery 41 by comparing the first battery ID corresponding to the vehicle ID that identifies the vehicle 40 and the second battery ID corresponding to the physical properties of the battery 41.

When xEVs are actually leased and rented for business use, the infrastructure varies from one operating entity to another. In particular, a challenge in terms of costs and operation is to limit, insofar as possible, the new investment required to secure a battery 41 for each of the vehicles 40. It is therefore preferable to be able to divert existing facilities, information, and equipment.

The determination system 1 of the present disclosure is independent of the configuration for acquiring the battery ID from the physical properties of the battery 41 and the configuration for determining the authenticity of the battery 41 by a comparison with the battery ID corresponding to the vehicle 40, so that the determination system 1 can be connected to existing facilities and equipment at low cost and with high versatility. According to the present disclosure, the information necessary for comparison and determination can therefore be acquired from external sources, thus ensuring expandability.

The present disclosure is not limited to the above embodiments. For example, a plurality of blocks described in the block diagrams may be integrated, or a block may be divided. Instead of a plurality of steps described in the flowcharts being executed in chronological order in accordance with the description, the plurality of steps may be executed in parallel or in a different order according to the processing capability of the apparatus that executes each step, or as required. For example, in FIG. 8, the controller 11 may perform the processing in steps S1 and S2 after performing the processing in steps S3 and S4. Alternatively, the controller 11 may, for example, perform the processing in steps S2 and S4 after performing the processing in steps S1 and S3. The controller 11 may also, for example, perform the processing in steps S3 and S4 in parallel with the processing in steps S1 and S2. Other modifications can be made without departing from the spirit of the present disclosure.

## Claims

1. A determination system comprising:
a sensor configured to measure physical properties of a target battery that is a battery installed in a vehicle; and
an information processing apparatus that is communicably connected to the sensor and comprises a controller, wherein
the controller is configured to
acquire vehicle identification information that identifies the vehicle,
acquire first battery identification information that identifies a battery corresponding to the acquired vehicle identification information,
acquire the physical properties of the target battery as measured by the sensor,
acquire second battery identification information that identifies a battery corresponding to the acquired physical properties,
compare the first battery identification information with the second battery identification information to determine authenticity of the target battery installed in the vehicle, and
output a result of determination of the authenticity of the target battery.

2. The determination system according to claim 1, further comprising a camera configured to capture and acquire an image of the vehicle, wherein
the controller is configured to acquire the vehicle identification information based on a result of analysis of the image acquired by the camera.

3. The determination system according to claim 2, wherein in a case in which the vehicle identification information could not be acquired based on the result of analysis of the image, the controller is configured to perform at least one of outputting an alert and repeating acquisition of the image of the vehicle by the camera.

4. The determination system according to claim 1, wherein the controller is configured to
receive, from a user, input of specific information for specifying the vehicle, and
acquire the vehicle identification information based on the specific information for which input is received.

5. The determination system according to any one of claims 1 to 4, wherein the controller is configured to acquire a measured value of leakage flux of the target battery as the physical properties of the target battery.

6. An information processing apparatus comprising a controller configured to:
acquire vehicle identification information that identifies a vehicle,
acquire first battery identification information that identifies a battery corresponding to the acquired vehicle identification information,
acquire, via a sensor, physical properties of a target battery that is a battery installed in the vehicle,
acquire second battery identification information that identifies a battery corresponding to the acquired physical properties,
compare the first battery identification information with the second battery identification information to determine authenticity of the target battery installed in the vehicle, and
output a result of determination of the authenticity of the target battery.

7. A determination method for an information processing apparatus comprising a controller, the determination method comprising:
acquiring, by the controller, vehicle identification information that identifies a vehicle;
acquiring, by the controller, first battery identification information that identifies a battery corresponding to the acquired vehicle identification information;
acquiring, by the controller via a sensor, physical properties of a target battery that is a battery installed in the vehicle;
acquiring, by the controller, second battery identification information that identifies a battery corresponding to the acquired physical properties;
comparing, by the controller, the first battery identification information with the second battery identification information to determine authenticity of the target battery installed in the vehicle; and
outputting, by the controller, a result of determination of the authenticity of the target battery.

8. A program configured to cause a computer to perform operations comprising:
acquiring vehicle identification information that identifies a vehicle;
acquiring first battery identification information that identifies a battery corresponding to the acquired vehicle identification information;
acquiring physical properties of a target battery that is a battery installed in the vehicle;
acquiring second battery identification information that identifies a battery corresponding to the acquired physical properties;
comparing the first battery identification information with the second battery identification information to determine authenticity of the target battery installed in the vehicle; and
outputting a result of determination of the authenticity of the target battery.
